# EUROPEAN PATENT APPLICATION

(11) **EP 1 583 189 A2**
(43) Date of publication of application: **05.10.2005**
(21) Application number: 05006446.8
(22) Date of filing: 23.03.2005
(51) Int. Cl.: H01S 5/20

(54) **Semiconductor laser and method for producing the same**

(30) Priority: 31.03.2004 JP 2004104805
(71) Applicant: TOYODA GOSEI CO., LTD., Aichi-ken, 452-8564 (JP)
(72) Inventor: Nakamura, Ryo, c/o Toyoda Gosei Co. Ltd., Nishikasugai-gun Aichi-ken 452-8564 (JP); Watanabe, Yasuhiro, c/o Toyoda Gosei Co. Ltd., Nishikasugai-gun Aichi-ken 452-8564 (JP); Tomita, Kazuyoshi, c/o K.K. Toyota Chuo Kenkyusho, Aichi-gun, Aichi-ken, 480-1192 (JP)
(74) Representative: TBK-Patent

(57) **Abstract**

Because height H and height h are sufficiently large as shown in FIG. 2, a semiconductor layer formed above the convex part through crystal growth always has thickness smaller than a semiconductor layer formed at the central part of the cavity (concave part existing between two convex parts). That tends to occur until at least the active layer 106 is completed. As a result, a window structure, which has band gap energy sufficiently larger than the central portion of the cavity owing to its quantum size effect, can be obtained around the output facet of the cavity. Also, an n-type clad layer 104 is formed between the etching plane having etching damage and the semiconductor layer constructing a waveguide. That enables to relax or overcome negative effect which is caused by damage left on the etching plane toward crystallinity of the waveguide.

## Description

### Technical Field

The present invention relates to the window structure of a cavity facet of an edge-emitting type semiconductor laser.

So the present invention greatly contributes to improve various kinds of device characteristics such as output ability or life of a semiconductor laser.

### Background Art

Window structure of a laser cavity facet in an edge-emitting type semiconductor laser (referred as "facet window structure" or simply "window structure" hereinafter) is a structure in which an optical output facet of a semiconductor laser is processed in order that the lights to be outputted or oscillated can be prevented from being absorbed around the facet. By employing this window structure, the threshold level at which catastrophe optical damage (COD) is occurred at the optical output facet can be increased, and that enables to improve luminous output and reliability of the device under conditions that temperature and luminous output are high.

A device having thus-designed facet window structure has been well-known as a device shown in Japanese Patent Application Laid-open No. 2001-210907 and Japanese Patent Application Laid-open No. H5-343813. The Japanese Patent Application Laid-open No. 2001-210907 discloses a structure which expands band gap energy around the facet by doping impurities such as zinc (Zn), while the Japanese patent Application Laid-open No. H5-343813 discloses a structure which expands band gap energy around the facet owing to well-known quantum size effect.

### Disclosure of the present invention

### Problems to be solved in the invention

The Japanese Patent Application Laid-open No. 2001-210907, however, has difficulty in controlling diffusion of impurities appropriately and optimally in a process for manufacturing the device.

And a method for doping and diffusing impurities by injecting ions tends to generate optical absorption and defects in the semiconductor layer, which results in decreasing reliability of the device.

In the Japanese patent Application Laid-open No. H5-343813, the following problems tend to occur.

That is, when a groove is formed along with the oscillation direction of a cavity by etching, serious damage is generated in crystallinity of the sidewalls of the groove. This damage causes crystal defects such as point defect and dislocation in the semiconductor layer which is deposited to form an optical waveguide, and decreases reliability of the device.

The present invention has been accomplished in an attempt to solve the aforementioned problems, and an object of the present invention is to obtain an edge-emitting type of semiconductor laser having effective facet window structure without generating crystal defects in an optical waveguide.

### Means to solve the problems

In order to overcome the above-described drawbacks, the followings may be useful.

That is, a first aspect of the present invention is an edge-emitting type semiconductor laser comprising: a crystal growth substrate; semiconductor layers including an active layer formed on said crystal growth substrate; and a projection part projecting to the active layer side, wherein the projection part is formed at a portion, on which an optical output facet of a laser cavity is formed, on a crystal growth plane on which said active layer is deposited, and band gap energy of a quantum-well layer in said active layer which exists at the upper portion of said projection part is larger than band gap energy of a quantum-well layer which exists at any part other than said projection part.

A convex part, i.e., a base to form a projection part, which is formed previously to form said projection part may be formed on the substrate and alternatively may be formed on the semiconductor layer formed on the substrate.

The projection part is not necessarily formed just on the optical output edge plane of the cavity. That is, the projection parts may be formed on the places near to both of the front edge plane which outputs a laser light and the back edge plane which does not output a laser light of the laser cavity.

The crystal growth substrate may be made of a well-known and arbitrary material. Conductivity of the crystal growth substrate may not be limited. The semiconductor layers which are formed through crystal growth may have arbitrary composition. Structure of the active layer may be MQW (multiple quantum-well) structure or SQW (single quantum-well) structure. Accordingly, the present invention may include any of the arbitrary conditions, and any edge emitting type of device may be applied as an arbitrary semiconductor laser.

The second aspect of the present invention is that a height h of the projection part is 7nm or more.

The third aspect of the present invention is that a height h of the projection part is in a range from 50nm to 100nm.

The fourth aspect of the present invention is that a width w of the projection part in the oscillation direction of the cavity is in a range from 1µm to 50µm.

The fifth aspect of the present invention is that the portion of the active layer on the projection part is a region to which electric current is not injected.

The sixth aspect of the present invention is that the positive electrode is formed except the portion above the projection part in order to form the region to which electric current is not injected.

The seventh aspect of the present invention is that an insulation layer is formed above the projection part in order to form the region to which electric current is not injected.

The eighth aspect of the present invention is a method for manufacturing an edge-emitting type semiconductor laser which is produced by forming semiconductor layers including an active layer through crystal growth in sequence on a crystal growth substrate, comprising: forming a convex part which projects to the upside at a portion on which an optical output facet of a laser cavity is to be formed, before forming a crystal growth plane on which the bottom layer of semiconductor layers constructing an optical waveguide including the active layer is formed; and depositing semiconductor layers including an active layer on a crystal growth plane including the convex part, to form a quantum-well layer of the active layer formed at the upper portion of the convex part thinner than a quantum-well layer of the active layer formed at the other part except at the upper portion of the convex part, wherein band gap energy of a quantum-well layer of the active layer formed at the upper portion of the convex part becomes larger than that of a quantum-well layer of the active layer formed at any part other than the upper portion of the convex part.

Preferably, the convex part described above may be formed before the uppermost surface of an n-type clad layer is formed. More preferably, the convex part may be formed on other layers including the n-type contact layer and the substrate, which are closer to the crystal growth substrate than the n-type clad layer.

An arbitrary treatment such as well-known dry-etching and wet-etching may be employed for etching the upper surface of the semiconductor layer and the upper surface of the crystal growth substrate.

Generally, a semiconductor laser is manufactured by forming a number of devices (semiconductor lasers) on one sheet of semiconductor wafer and then dividing the wafer into each device. With respect to this dividing process, generally a facet of a cavity is obtained by cleavage. Accordingly, by forming a projection part and a convex part having twice a width of the above-described width w on the semiconductor wafer and cleaving the projection part and the convex part at the center of the width 2w, both of the semiconductor lasers divided by that cleavage can have window structure each of which comprises the projection part and the convex part having a width w. Because this cleavage does not require any margin to divide, an appropriate range of the width 2w of the projection part in the oscillation direction which is to be formed on the semiconductor wafer may be around 10µm to 100µm according to the fourth aspect of the present invention described above. More preferably, the width 2w may be in a range from 20µm to 50µm.

Through employment of the aforementioned aspects of the present invention, the aforementioned drawbacks can be overcome effectively and rationally.

### Effect of the invention

Effects to be obtained by the present invention are explained as follows.

That is, according to the first aspect of the present invention, thickness of the quantum-well layer of the active layer which is deposited at the upper portion of the projection part becomes smaller than that of the quantum-well layer of the active layer which is deposited at the other part except at the upper portion of the projection part. With respect to a crystal growth plane having ruggedness, driving force for crystallization works to minimize surface energy. As a result, the crystal growth plane becomes flat as crystal growth proceeds.

Owing to that action and the well-known quantum size effect, band gap energy around the edge facet of the active layer becomes bigger than the band gap energy inside of the cavity, and light absorption and nonradiative recombination at the facet of the cavity hardly occur. As a result, according to the first aspect of the present invention, reliability and output efficiency of the device can be improved.

It is adequate that the projection part is formed at least at a light output facet side.

Alternative the projection parts may be formed around the front facet and the back facet of the cavity. When the projection parts are formed around both of the front facet and the back facet of the cavity, both facets of the cavity have the same structure. That makes it unnecessary to distinguish the front facet and the back facet of the cavity. As a result, by forming the projection part at each facet of the cavity, productivity of a device can be improved.

Preferably, height h of the projection part may be 7nm or more (the second aspect of the present invention). More preferably, height h of the projection part may be in a range from 50nm to 100nm (the third aspect of the present invention). By employing the second or the third aspect of the present invention, actions and effects of the present invention explained above can be obtained more surely. Further, it enables to prevent from carrying out etching to a degree which is unnecessarily and unwillingly deep.

And by forming the projection part to have a width w in oscillation direction of the cavity in a range from 1µm to 50µm (the fourth aspect of the present invention), window structure which prevents nonradiative recombination at the optical output facet, or necessary and sufficient size of region which does not absorb lights, can be obtained. When the thickness (width w) is too small, sufficient length of the region which does not absorb lights in oscillation direction cannot be obtained and actions and effect described above can hardly be obtained. When the thickness (width w) is too large, loss of lights becomes larger, resulting in increasing threshold electric current and decreasing output ability. The width w of the projection part may more preferably be from 10µm to 25µm.

By using the portion deposited on the projection part in the active layer as a region to which no electric current is injected (the fifth aspect of the present invention), the emission of light whose wavelength does not contribute to laser oscillation can be suppressed, and that enables to decrease spontaneous light emitting, or noise. Also, heat generation owing to electric current and light emission may also be suppressed. As a more concrete method to obtain those actions and effects, the sixth or the seventh aspect of the present invention, for example, is useful.

According to the eighth aspect of the present invention, the semiconductor laser having effective facet window structure can be manufactured easily and effectively.

When the convex part is formed, a part whose crystallinity is damaged owing to its shape: e.g., a part with etching damage, is left on a plane where the convex part is formed, or a new crystal growth plane. According to the above-described method, however, a semiconductor layer which constructs a waveguide may not be deposited directly on the new crystal growth plane. In short, a semiconductor layer which does not construct the waveguide, e.g., an n-type layer, can be arranged between the new crystal growth plane and the semiconductor layer which constructs the waveguide and the semiconductor layer can be grown through crystal growth excellently so that crystal defects decrease according to the growth.

That is, according to the above-described method, negative influence toward crystallinity of the semiconductor layer, which a crystallinity damaged part left on the new crystal growth plane affects if the semiconductor layer is formed directly on the new crystal growth plane, can be relaxed or removed according to crystal growth of such an intermediate layer. Accordingly, by employing the above-described processes, conventional problems with respect to quality of a crystal which constructs an optical waveguide of a cavity can be relaxed or overcome.

According to the present invention, the semiconductor laser can be obtained only by carrying out etching described above in addition to the conventional manufacturing method.

Thus, according to the eighth aspect of the present invention, effective facet window structure may be obtained without generating problems with respect to crystallinity in the waveguide.

### Brief Description of the Drawings

FIG. 1 is a cross-sectional view of a semiconductor laser 100 which is seen from the direction perpendicular to the oscillation direction according to a first embodiment of the present invention.
FIG. 2 is a cross-sectional view of a semiconductor laser 100 which is seen from the direction parallel to the oscillation direction according to a first embodiment of the present invention.
FIG. 3 is a perspective view of a semiconductor laser 100 after a convex part is formed according to a first embodiment of the present invention.

### Best Mode for Carrying Out the Invention

Embodiments of the present invention will next be described with reference to the drawings. Characteristic features of the present invention have been described above are also the best mode for carrying out the invention, and the present invention is not limited to the below-described specific embodiments.

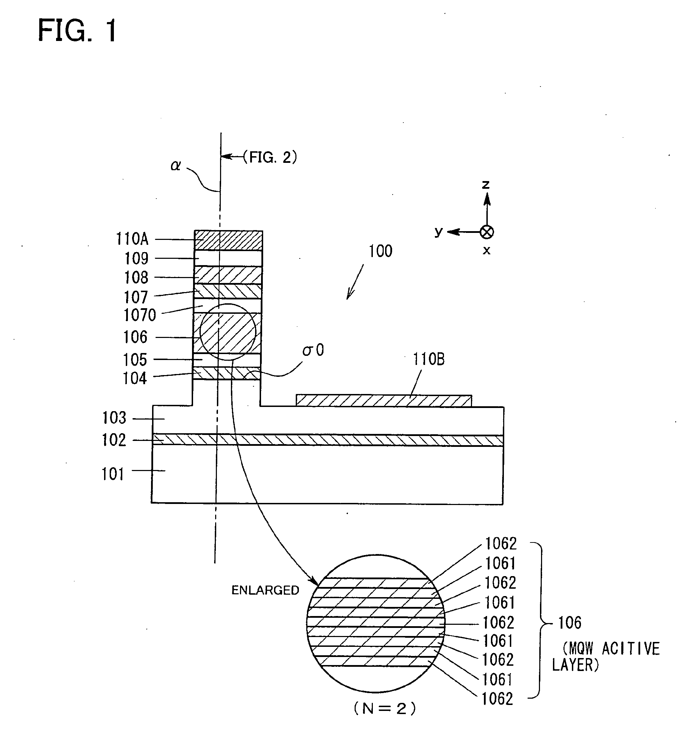

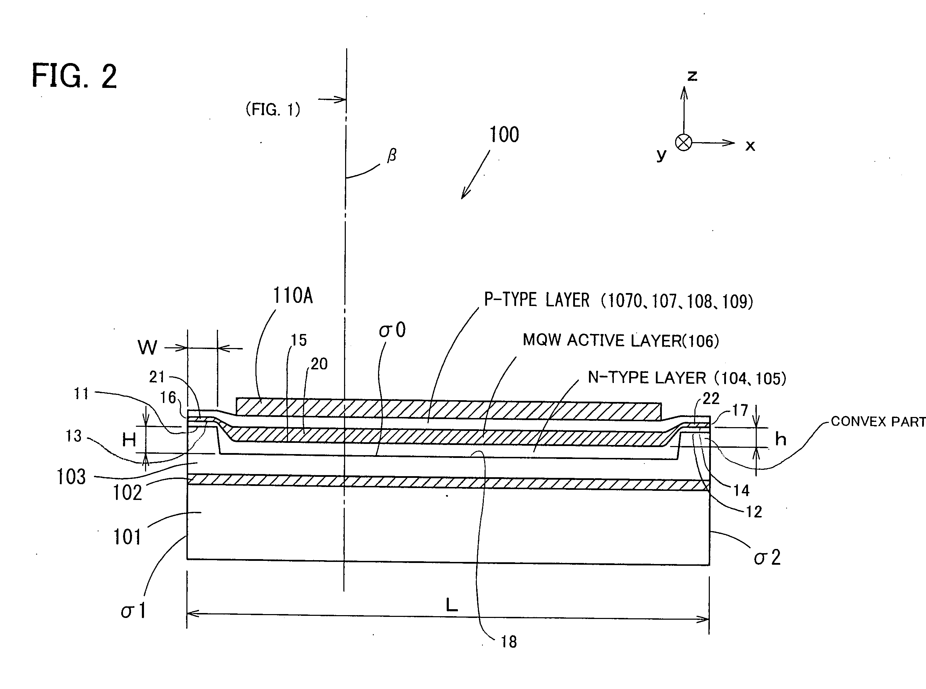

FIG. 1 is a sectional view of a semiconductor laser 100 which is seen from the direction perpendicular to the oscillation direction (: x-axis direction) according to a first embodiment of the present invention. FIG. 2 is a sectional view of the semiconductor laser 100 which is seen from the direction parallel to the oscillation direction. In short, FIG. 2 is a view of the sectional plane α shown in FIG. 1, while FIG. 1 is a view of the sectional plane β shown in FIG. 2.

The semiconductor laser 100 has a crystal growth substrate 101 made of sapphire, and an aluminum nitride (AlN) buffer layer 102 is formed on the substrate 101. On the buffer layer 102, a silicon (Si) doped GaN n-type contact layer 103 having a thickness of about 5.0µm is formed.

In FIGS. 1 and 2, σ0 represents the exposed plane on the upper side of the n-type contact layer 103 which is formed to have enough thickness and dry-etched from its upper side. And in FIG. 2, each σ1 and σ2 represents the cleavages perpendicular to the oscillation direction including the facets of a cavity.

On the n-type contact layer 103, a silicon (Si) doped Al_{0.08}Ga_{0.92}N n-type clad layer 104 having a thickness of about 1µm and an electron concentration of 2 x 10¹⁸/cm³ is formed. On the n-type clad layer 104, an n-type optical guide layer 105 having a thickness of about 100nm is formed. The n-type optical guide layer 105 is formed by depositing a silicon doped GaN which has an electron concentration of 2 x 10¹⁸/cm³ until its thickness becomes 100nm.

On the n-type optical guide layer 105, an active layer 106 of MQW structure, in which 5 GaN quantum-barrier layers 1062 each having a thickness of about 70Å and 4 In_{0.15}Ga_{0.85}N quantum-well layers 1061 each having a thickness of about 35Å are deposited alternately to comprise 9 layers in total, is formed. The upper surface 15 of the n-type optical guide layer 105 is the crystal growth plane on which the active layer 106 is deposited.

On the active layer 106, an Al_{0.2}Ga_{0.8}N p-type stopper layer 1070 is formed. The p-type stopper layer 1070, having a thickness of 20nm and carrier concentration of 5 x 10¹⁷/cm⁻³, is formed by doping magnesium (Mg) through crystal growth.

On the p-type stopper layer 1070, about 100nm in thickness of a p-type optical guide layer 107 is formed. The p-type optical guide layer 107 is formed by depositing magnesium (Mg) doped GaN which has a hole concentration of 5 x 10¹⁷/cm³ until its thickness becomes 100nm.

On the p-type optical guide layer 107, a magnesium (Mg) doped Al_{0.08}Ga_{0.92}N p-type clad layer 108, having a thickness of about 1µm and a hole concentration of 3 x 10¹⁷/cm³, is formed. On the p-type clad layer 108, a magnesium (Mg) doped GaN p-type contact layer 109, having a thickness of about 300nm and a hole concentration 5 x 10¹⁷/cm³, is formed. On the p-type contact layer 109, a positive electrode 110A made of nickel (Ni) is formed. And a negative electrode 110B made of aluminum (Al) is formed on the n-type contact layer 103.

Next, a method for manufacturing the semiconductor laser 100 is explained hereinafter.

The semiconductor laser 100 is formed by gaseous phase epitaxial growth, called metal organic vapor phase epitaxy (hereinafter MOVPE). The gases employed in this process were ammonia (NH₃), a carrier gas (H₂, N₂), trimethyl gallium (Ga(CH₃)₃) (hereinafter TMG), trimethyl aluminum (Al(CH₃)₃) (hereinafter TMA), trimethyl indium (In(CH₃)₃) (hereinafter TMI), silane (SiH₄), and biscyclopentadienyl magnesium (Mg(C₅H₅)₂) (hereinafter CP₂Mg).

The sapphire substrate 101 was placed on a susceptor in a reaction chamber of the MOVPE equipment after it was cleaned by an organic washing solvent and heat treatment. Then the sapphire substrate 101 was baked for about 30 min. at 1100°C by H₂ vapor fed into the chamber under normal pressure.

About 25nm in thickness of AIN buffer layer 102 was formed on the surface of the baked sapphire substrate 101 under conditions controlled by lowering the temperature in the chamber to 400°C, keeping the temperature constant, and concurrently supplying H₂, NH₃, and TMA.

About 5.0µm in thickness of GaN n-type contact layer 103 was formed on the buffer layer 102 under conditions controlled by increasing the temperature of the sapphire substrate 101 to 1150°C and concurrently supplying H₂, NH₃, TMG, and silane (SiH₄).

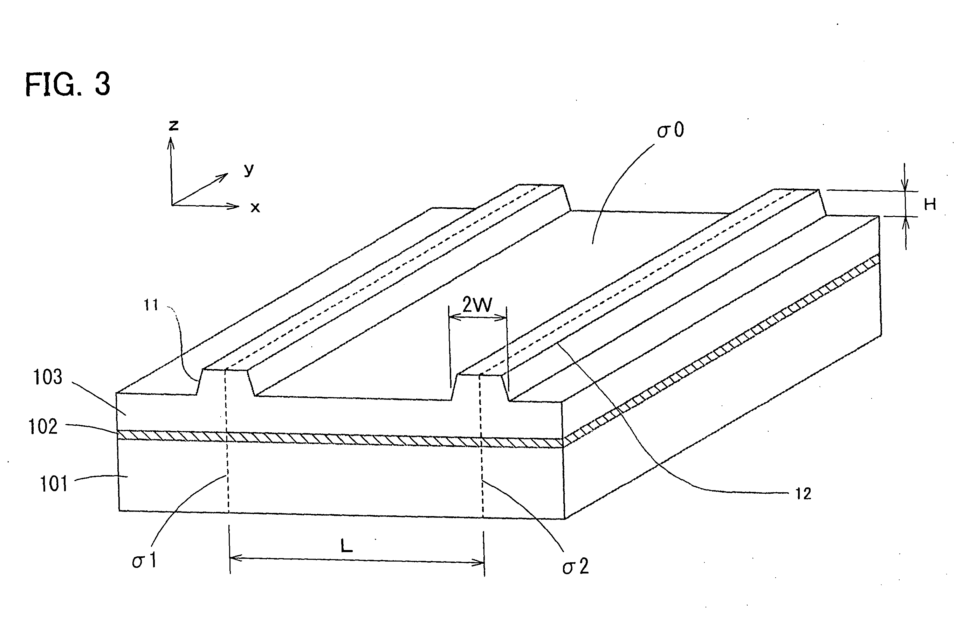

Next, the upper surface of the n-type contact layer 103 was dry-etched by using an etching equipment. FIG. 3 is a perspective view of the semiconductor laser 100 after convex parts 11 and 12 are formed on the n-type contact layer 103 by carrying out this dry-etching treatment, each of which exists near each of the cavity facets 16 and 17.

In FIG. 3, σ0 is an exposed plane formed by dry-etching the surface of the n-type contact layer 103 which has been formed to have enough thickness as described above. And σ1 and σ2 cavity cleavage planes (or planned cleavage planes) perpendicular to the oscillation direction of the laser cavity.

The convex parts 11 and 12 are formed on the n-type contact layer 103 in a stripe pattern whose longitudinal direction is in the y-axis direction (width direction of the cavity) and the width 2w of the stripe pattern along the oscillation direction (x-axis direction) is about 50µm. And the height H of the convex part is about 100nm. That is, dry-etching is carried out to about 100nm in depth. A distance L between the planes σ1 and σ2 which are to be cleaved is about 600µm. This is the distance between each facet of the laser cavity.

After carrying out the dry-etching treatment, MOVPE treatment is employed again and about 1µm in thickness of silicon (Si) doped Al_{0.08}Ga_{0.92}N n-type clad layer 104 is formed under conditions controlled by keeping the temperature of the sapphire substrate 101 at 1100°C, and concurrently supplying N₂ or H₂, NH₃, TMA, TMG, and silane (SiH₄).

Here, as shown in FIG. 2, each semiconductor layer grown on the convex parts 11 and 12 through crystal growth tends to have a thickness smaller than the central portion 20 (concave part between two projection parts) of the cavity. And this phenomenon continues until at least the formation of the active layer 106 has been finished. That is because height H of the convex parts 11 and 12 are high enough as shown in FIG. 2 and the concave part 18 with sufficient depth may not be filled even when the active layer 106 is formed.

And, each thickness of the n-type clad layer 104 and other layers illustrated in FIG. 1 which is explained above is a thickness at the central portion of the cavity (the concave part 18 between two convex parts 11 and 12).

After forming the n-type clad layer 104, about 100nm in thickness of silicon (Si) doped GaN n-type optical guide layer 105 is formed under conditions controlled by concurrently supplying N₂ or H₂, NH₃, TMG, and silane (SiH₄). The upper surface 15 of the n-type optical guide layer 105 is formed having projection parts 16 and 17 above the convex parts 11 and 12, respectively, as shown in FIG. 2.

The upper surface 15 of the n-type optical guide layer 105 is the crystal growth plane for which the active layer 106 is formed. The upper surface 15 as the crystal growth plane has steps with height h of 50nm on both sides, which construct the projection parts 13 and 14 on the convex parts 11 and 12, respectively. The height h may be 7nm or more. More preferably the height h may be 50nm to 100nm.

Next, an active layer 106 comprising 9 layers in total is formed on the crystal growth plane 15 of the n-type optical guide layer 105.

At first, by lowering the temperature of the substrate 101 to 730°C, changing the carrier gas from H₂ to N₂, concurrently supplying the carrier gas and NH₃, keeping each supply amount constant and further supplying TMG, about 7nm in thickness of GaN quantum-barrier layer 1062 is obtained through crystal growth.

Next, about 3.5nm in thickness of In_{0.15}Ga_{0.85}N quantum-well layer 1061 is formed on the quantum-barrier layer 1062 under conditions controlled by concurrently supplying N₂, NH₃, TMG, and TMI.

The quantum-barrier layer 1062 and the quantum-well layer 1061 are formed alternately to thereby obtain the active layer 106 comprising 9 layers in total.

The thickness of the active layer 106 on the projection parts 13 and 14, or above the convex parts 11 and 12 become smaller than that of the central portion 20 owing to the steps on the both side of the cavity.

Next, about 40nm in thickness of Al_{0.2}Ga_{0.8}N p-type stopper layer 1070 is formed on the active layer 106 under conditions controlled by increasing the temperature of the sapphire substrate 101 to 1100°C, and concurrently supplying N₂ or H₂, NH₃, TMG, TMA, and CP₂Mg. The p-type stopper layer 1070 functions to prevent overflow of carriers.

About 100nm in thickness of GaN p-type optical guide layer 107 is formed under conditions concurrently supplying N₂ or H₂, NH₃, TMG, and CP₂Mg. About 1µm in thickness of magnesium (Mg) doped Al_{0.08}Ga_{0.92}N p-type clad layer 108 is formed under conditions concurrently supplying N₂ or H₂, NH₃, TMA, TMG, and CP₂Mg.

About 300nm in thickness of magnesium (Mg) doped GaN p-type contact layer 109 is formed under conditions controlled by keeping the temperature of the sapphire substrate 101 at 1100°C, and concurrently supplying N₂ or H₂, NH₃, TMG, and CP₂Mg.

Subsequently, the p-type contact layer 109, the p-type clad layer 108, the p-type optical guide layer 107, and the p-type stopper layer 1070 are uniformly irradiated with electron beams by use of an electron beam irradiation apparatus. Through irradiation of electron beams, the hole densities of the p-type contact layer 109, the p-type clad layer 108, the p-type optical guide layer 107, and the p-type stopper layer 1070 became 5 x 10¹⁷/cm³, 3 x 10¹⁷/cm³, 5 x 10¹⁷/cm³, and 5 x 10¹⁷/cm³, respectively. Thus, a wafer having a multi-layer structure was produced.

Next, a SiO₂ layer is formed by sputtering, and a photoresist layer is laminated on the SiO₂ layer. Then photolithography is carried out. The photoresist layer of the resion in which an electrode is to be formed on of the n-type contact layer 103 is removed by using photolithography. And the SiO₂ layer, which is not covered by the photoresist layer, was removed by using hydrofluoric acid based etching solution.

The portion of the p-contact layer 109, the p-type clad layer 108, the p-type optical guide layer 107, the p-type stopper layer 1070, the active layer 106, the n-type optical guide layer 105, the n-type clad layer 104, and the n-type contact layer 103, each of which is not covered by the photoresist layer and the SiO₂ layer, is dry-etched. This dry-etching treatment provides a region for taking out a negative electrode to the n-type contact layer 103.

Next, nickel (Ni) is deposited to form a positive electrode 110A on the p-type contact layer 109. On the n-type contact layer 103, aluminum (Al) is deposited to form the negative electrode 110B.

Here, the positive electrode 110A is formed except above the upper portion of the convex parts 11 and 12 of the n-type contact layer 103. As a result, parts of the active layer 106, which are formed above the convex parts 11 and 12 of the n-type contact layer 103, can become region to which electric current is not injected.

Scribing is in oscillation direction (: x-axis direction) of the cavity is carried out to obtain a scribing groove, dicing is carried out to obtain a strip of the semiconductor wafer, and further cleaving treatment is carried out to form cavity facets 16 and 17 (cleavage planes σ1 and σ2).

The thus-obtained semiconductor laser 100 in the first embodiment of the present invention oscillates well under at driving current of 1.2A and luminous output 1W.

Then, the photoluminescence of the active layer is measured by using the semiconductor wafer of the semiconductor laser 100 before forming the p-type stopper layer 1070 as a sample. Luminous wavelength of the light emitted from the window parts 21 and 22 (the upper portions of the projection parts 13 and 14 of the crystal growth plane 15, i.e., the portions above the convex parts 11 and 12 of the n-type contact layer 103) of the active layer is 403nm, while luminous wavelength of the light emitted from the central part 20 of the cavity of the active layer 106 is 416nm. Accordingly, owing to the above-described structure, it becomes easier to form an effective window structure, which can provide sufficient band gap energy difference in conversion to wavelength, i.e., 13nm of luminous wavelength difference, on each facet of the cavity, compared with the prior inventions.

By forming the window structure at each mirror plane of the cavity, an edge emitting type of semiconductor laser having effective facet window structure can be obtained without generating crystal defects in an optical wave guide.

### [Other Modified Embodiment]

While the present invention has described with reference to the above embodiments as the most practical and optimum ones, the present invention is not limited thereto, but may be modified as appropriate without departing from the spirit of the invention.

### (Modified Embodiment 1)

For example, the sapphire substrate is used as a crystal growth substrate in the above-described first embodiment. Alternately, other general and well-know material can be applied to the crystal growth substrate. For example, a GaN bulk substrate may be employed.

### (Modified Embodiment 2)

In the first embodiment, the convex parts 11 and 12 are formed by carrying out dry-etching to the n-type contact layer 103. Alternatively, the convex parts which are used for forming the window structure of the present invention can be formed in any of the processes before the crystal growth plane for growing the lowermost layer of the semiconductor layer which comprises the optical waveguide with the active layer is formed.

More preferably, the convex part may be formed at at least one of the n-type contact layer 103 and the crystal growth substrate 101. By forming the convex part in the earlier stage, crystallinity of the optical waveguide can be improved more. Regardless to say, easiness for carrying out etching, such as degree of hardness of the crystal growth substrate, needs to be considered.

In the above-described embodiment, the convex part is formed through etching. Alternately, it may be formed through other processes including mechanical treatment such as grinding treatment and a process using a laser.

Further alternative, only the convex parts 11 and 12 may be selectively grown by masking the central part 20 using resin. The mask may be removed after the convex parts are obtained.

### (Modified Embodiment 3)

When a GaN bulk substrate is used as a crystal growth substrate, the following advantages can be obtained.
(1) The convex part can be formed on the GaN bulk substrate at first. That enables to form the convex part easier compared with forming the convex part on a sapphire substrate. Also, that makes it comparatively easy to grow a semiconductor crystal with more excellent crystallinity on the convex part.
(2) It is not necessary to deposit a buffer layer.

In the first embodiment of the present invention, the active layer has MQW structure. Alternatively, the active layer may have other arbitrary structure such as SQW structure. In the first embodiment of the present invention, crystal growth is carried out by employing MOVPE treatment. Alternatively, other arbitrary crystal growth method may be applied. Also alternatively, other arbitrary method such as wet-etching may be employed as a method for forming the projection part.

### Industrial Applicability

The present invention relates to structure of a window of an edge-emitting type semiconductor laser. And the present invention can also be applied to an arbitrary edge emitting type of semiconductor laser.

While the present invention has been described with reference to the above embodiments as the most practical and optimum ones, the present invention is not limited thereto, but may be modified as appropriate without departing from the spirit of the invention.

Because height H and height h are sufficiently large as shown in FIG. 2, a semiconductor layer formed above the convex part through crystal growth always has thickness smaller than a semiconductor layer formed at the central part of the cavity (concave part existing between two convex parts). That tends to occur until at least the active layer 106 is completed. As a result, a window structure, which has band gap energy sufficiently larger than the central portion of the cavity owing to its quantum size effect, can be obtained around the output facet of the cavity. Also, an n-type clad layer 104 is formed between the etching plane having etching damage and the semiconductor layer constructing a waveguide. That enables to relax or overcome negative effect which is caused by damage left on the etching plane toward crystallinity of the waveguide.

## Claims

1. An edge-emitting type semiconductor laser comprising a crystal growth substrate and a semiconductor layers including an active layer formed on said crystal growth substrate **characterized in that**
a projection part projecting to said active layer side is formed at a portion, on which an optical output facet of a laser cavity is formed, on a crystal growth plane on which said active layer is deposited, and band gap energy of a quantum-well layer in said active layer which exists at the upper portion of said projection part is larger than band gap energy of a quantum-well layer which exists at any part other than said projection part.

2. The semiconductor laser according to claim 1,
wherein a height h of said projection part is 7nm or more.

3. The semiconductor laser according to claim 1,
wherein a height h of said projection part is in a range from 50nm to 100nm.

4. The semiconductor laser according to claim 1,
wherein a width w of said projection part in the oscillation direction of said laser cavity is in a range from 1µm to 50µm.

5. The semiconductor laser according to claim 1,
wherein the portion of said active layer on said projection part is a region to which electric current is not injected.

6. The semiconductor laser according to claim 5,
wherein a positive electrode is formed except said portion above said projection part in order to form said region to which electric current is not injected.

7. The semiconductor laser according to claim 5,
wherein an insulation layer is formed above said projection part in order to form said region to which electric current is not injected.

8. A method for manufacturing an edge-emitting type semiconductor laser which is produced by forming semiconductor layers including an active layer through crystal growth in sequence on a crystal growth substrate **characterized in that** said method comprises:
forming a convex part which projects to the upside at a portion on which an optical output facet of a laser cavity is to be formed, before forming a crystal growth plane on which the bottom layer of semiconductor layers constructing an optical waveguide including said active layer is formed; and
depositing semiconductor layers including an active layer on a crystal growth plane including said convex part, to form a quantum-well layer of said active laer formed at an upper portion of said convex part thinner than a quantum-well layer of said active layer formed at the other part except at said upper portion of said convex part, wherein band gap energy of a quantum-well layer of said active layer formed at the upper portion of said convex part becomes larger than that of a quantum-well layer of said active layer formed at any part other than the upper portion of said convex part.
